Europäisches Patentamt

European Patent Office

Office européen des brevets

(19)

(11) **EP 0 981 758 B1**

(12) **EUROPEAN PATENT SPECIFICATION**

(45) Date of publication and mention
of the grant of the patent:
**28.08.2002 Bulletin 2002/35**

(51) Int Cl.⁷: $G01R\ 31/36$, $G01D\ 4/00$

(21) Application number: **98919384.2**

(86) International application number:
**PCT/GB98/01298**

(22) Date of filing: **05.05.1998**

(87) International publication number:
**WO 98/052061 (19.11.1998 Gazette 1998/46)**

(54) **BATTERY MONITORING IN METERING SYSTEMS**

BATTERIEÜBERWACHUNG IN ZÄHLERSYSTEMEN

SYSTEME DE CONTROLE DE BATTERIE DANS DES INSTALLATIONS DE COMPTAGE

(84) Designated Contracting States:
**AT BE CH CY DE DK ES FI FR GB GR IE IT LI LU
MC NL PT SE**

(30) Priority: **12.05.1997 GB 9709603**

(43) Date of publication of application:
**01.03.2000 Bulletin 2000/09**

(73) Proprietor: **Siemens Metering Limited
Oldbury, Bracknell, Berkshire, RG12 8FZ (GB)**

(72) Inventor: **DUJON, Gregory, Francis
Gnosall, Staffordshire ST20 0DR (GB)**

(74) Representative: **Allen, Derek et al
Siemens Group Services Limited,
Intellectual Property Department,
Siemens House,
Oldbury
Bracknell, Berkshire RG12 8FZ (GB)**

(56) References cited:
**EP-A- 0 248 137        EP-A- 0 527 072
EP-A- 0 534 803**

• **DATABASE WPI Section EI, Week 9632 Derwent
Publications Ltd., London, GB; Class S01, AN
96-315521 XP002073700 -& JP 08 139 819 A
(YAZAKI CORP)**

**Description**

The present invention relates to the monitoring of batteries in metering systems for metering the supply of a service to a consumer.

In various metering systems, such as gas and water metering systems for example, the metering apparatus at the consumer's premises may be powered by battery. In such systems, it is necessary to monitor the battery capacity to determine when the batteries are nearing the end of their life so that they can be replaced in a controlled manner.

Monitoring of battery capacity to provide a "battery-low" warning to a user is of course performed in many battery powered devices. The usual method is to measure the battery voltage at regular intervals to estimate the remaining energy capacity and give a warning to the user when the capacity or voltage falls below a threshold. The threshold is selected to give enough warning to replace the batteries before the voltage falls to a level at which it cannot sustain correct operation of the device. The accuracy of the measurement will determine how low the threshold can be set to give enough safety margin. This in turn affects how much useful life can be achieved from the batteries before a battery-low condition is indicated. However, the remaining capacity of a battery is difficult to determine accurately because it is dependent on a number of factors. The battery voltage depends on current load and ambient temperature as well as the remaining capacity (which in turn is affected by the use of the battery thus far). The battery manufacturer can normally supply the battery characteristics in the form of a load curve which plots the battery voltage at a given load and temperature against the remaining capacity in Ampere-hours. Different types of batteries such as zinc, alkaline and lithium batteries have different load curves and are affected in different ways by the loads placed upon them, some working best with low continuous loads while others give good performance with high loads, either continuous or pulsed.

Thus. to obtain an accurate indication of remaining battery capacity it would be necessary to measure the ambient temperature and the battery voltage under a known load, the measured voltage then being compared with the manufacturer's data or empirically derived figures to determine when the low battery threshold has been reached. The facility to take such measurements, and perform the necessary processing to accurately determine remaining battery capacity, cannot be provided in many devices for practical reasons. Thus, many devices simply use measured battery voltage as an indicator of remaining capacity. In particular, in prior battery powered metering apparatus, the apparatus merely measures the battery voltage at regular intervals and compares the measured voltage with a threshold. If the measured voltage is below the threshold, a battery-low warning in indicated to the consumer, so that the consumer can then call the service engineer to replace the battery.

JP-A-08 139 819 discloses an automatic reporting device for notifying meter inspection data of a commodity to an information centre. The reporting device comprises a detector for monitoring usage of the metered commodity and a battery-operated report unit for indicating the usage of the metered commodity. A battery lifetime detector is also provided for monitoring the voltage of the battery to provide an indication of its lifetime, the battery lifetime being transmitted to the report unit for transmission to the information centre.

In accordance with one aspect of the present invention, there is provided a metering system for metering the supply of a service to a consumer, the system comprising:-

    metering apparatus for metering the service;
    at least one battery for powering the metering apparatus;
    control means for controlling the metering apparatus and for recording battery usage data, the battery usage data comprising at least data indicating the operating time of the metering apparatus since insertion of the battery therein;
    data output means for outputting the battery usage data from the control means; and
    external data processing means for processing the battery usage data received from the data output means;

    characterised in that the external data processing means estimates the used capacity of the battery in accordance with the operating time and pre-stored data indicative of the energy consumption of the metering apparatus in standby mode of operation.

In embodiments of the present invention, therefore, the control means simply records the battery usage data, and this is output for communication to an external data processing means which can process the data to determine if the battery should be replaced. Since the processing to estimate battery capacity is performed externally of the metering apparatus, battery measurements and processing thereof by the metering apparatus is not required, so the operation can be simplified. Also, more sophisticated processing can be performed by the data processing means than could be performed practically by the metering apparatus, allowing more accurate estimates of battery capacity to be obtained and useful battery life to be extended.

The external data processing means may comprise a central controller, for example a computer at a control centre of the service provider which maintains consumer accounts/equipment service records etc. The battery usage data could be communicated to the central computer in a number of ways. For example, consumer metering apparatus often incorporates a card interface to enable the consumer to load the apparatus with credit, representing payment for the service, by inserting a memory card into the card interface unit. The consumer purchases credit by taking the card to a remote point of sale where payment is made and corresponding credit is written to the memory card. In such systems, the battery usage data can be written to the card when the consumer inserts the card in the metering apparatus to load purchased credit. The next time the card is taken to the point of sale to purchase further credit, the battery usage data can be read from the card by the point of sale terminal, and thus communicated to the service provider for processing. Alternatively, or in addition, the battery usage data may be output to a hand-held unit (hhu) as commonly used by service engineers to interface with the control circuitry of the metering apparatus for programming/diagnostic/data transfer operations etc. The hhu may itself constitute the external data processing means for processing the battery usage data to check the battery status. Alternatively, the hhu could simply collect the battery usage data from the meter, this being downloaded to the central control computer by the hhu when the engineer returns from a service visit.

As indicated above, the battery usage data comprises at least the operating time of the apparatus since insertion of the battery. The operating time alone may be sufficient to enable the external processing means to obtain a sufficiently reliable indication of the remaining battery capacity. In particular, for much of the operating time, the apparatus will normally be in a standby mode of operation and the standby current is a known, substantially stable value. Since the standby current is generally the dominant factor, an indication of remaining capacity can be obtained simply by subtracting the energy consumption, eg. in Ampere-hours, due to standby current over the operating time from the nominal battery capacity when new, accounting for factors such as battery self-discharge current etc. as appropriate. However, the external data processing means may be programmed with data indicating the expected operating pattern of the apparatus, eg. the typical frequency of occurrence of each of the various types of operations performed by the apparatus in use, and the average energy consumed by performing each operation. Depending on the operating time, therefore, the expected total energy consumption can be calculated to estimate the remaining battery capacity more accurately.

In preferred embodiments, in addition to the operating time the battery usage data recorded by the control means includes a record of the number of times each of a plurality of types of operation are performed by the apparatus. Since the amount of energy consumed by a metering apparatus in performing each type of operation can be preprogrammed in the external data processing means, the external data processing means can then determine the total energy consumption based on the particular operating pattern of the metering apparatus indicated by the battery usage data.

It is to be appreciated that, where features are described herein with reference to an apparatus according to the invention, corresponding features may be provided in a method of the invention and vice versa. In particular, a further aspect of the invention provides a method as set forth in claim 15.

Preferred embodiments of the invention will now be described, by way of example, with reference to the accompanying drawings in which:

Figure 1 is an overall schematic of the main elements of a gas metering system embodying the invention;
Figure 2 is a schematic block diagram of the consumer metering apparatus in the system of Figure 1;
Figure 3 is a schematic block diagram of the CDT controller of Figure 2; and
Figure 4 is a schematic block diagram of the meter controller of Figure 2.

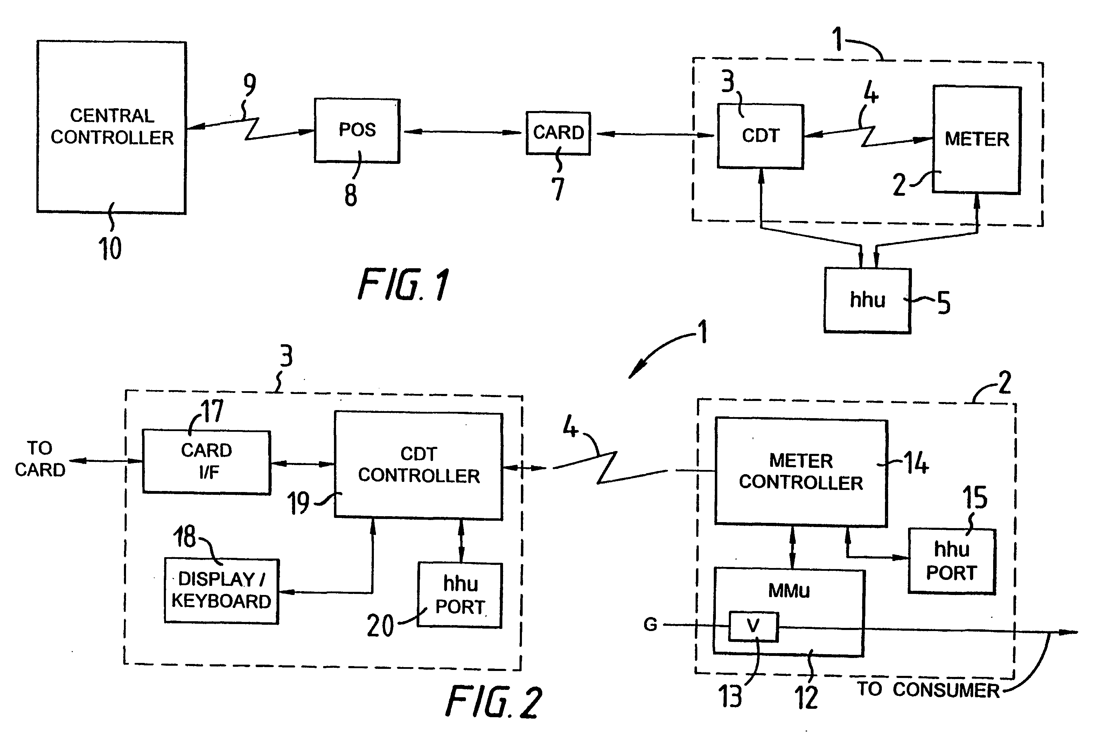

Referring to Figure 1, the metering apparatus 1 at the consumer's premises comprises a meter 2 for metering the gas supply to the consumer and a control unit 3 (hereinafter referred to as a Customer Display Terminal or CDT). The CDT 3 can communicate with the meter 2 via a communications link 4 which may be a wireless or hard-wired link as desired. The CDT 3 controls operation of the apparatus generally, for example to control the supply of gas to the consumer in dependence on available credit. Both the CDT 3 and meter 2 can also communicate with a hand-held unit (hhu) 5 used by the service engineer, eg. for programming, data retrieval, and various other service operations, when the engineer visits the consumer's premises.

The consumer is provided with a memory card 7, such as smart card or magnetic stripe card, which is used periodically to load credit to the metering apparatus 1. When the consumer wishes to purchase credit, he takes the card 7 to a point of sale terminal (POS) 8 which is located at a convenient public location. The card 7 is inserted in a card interface, of generally known type, of the POS terminal 8 and the desired payment is made to the POS operator. The operator keys this payment into the POS 8 which then writes the purchased credit (eg. as a monetary value or consumption units such as kilowatt hours of energy) to the card 7. The POS 8, along with the other similar POS terminals in use in the utility metering system, is connected via a communications link 9 to a central controller 10 of the system. The central controller 10 maintains the customer accounts, service records etc. required for overall management of the metering system. Thus, when the customer's card 7 is inserted in the POS 8 for a credit transaction, the payment data and various other data stored on the card 7 is communicated to the central controller 10 to update the central records.

Figure 2 illustrates the consumer metering apparatus 1 in more detail. The meter 2 comprises a basic mechanical meter unit (MMU) 12 which meters the gas supply G and incorporates a cut-off valve 13 which is selectively controllable to cut off the supply of gas to the consumer. The meter 1 also includes a meter controller 14 which receives the output pulses (indicating consumption of a fixed volume of gas) from the MMU 12. The meter controller 14 maintains a record of the meter reading in an internal memory and controls operation of the cut-off valve 13 in the MMU 12. The meter controller 14 is also connected to an hhu port 15, for example an opto-port of generally known type, to which the hhu 5 is connected by the service engineer to allow data communications with the meter controller 14. The power required for operation of the various elements of the meter 2 is supplied by battery (not shown), for example a single lithium battery.

The CDT 3 includes a card interface unit 17 of known type for transfer of data with the customer card 7 when the card is inserted in a slot (not shown) of the unit. The CDT 3 also includes a display and keypad indicated schematically at 18. The display is used for displaying messages, instructions etc. to the consumer, and the keypad can be used for entering various data, control inputs etc. as may be required for operation of the system. A CDT controller 19 controls operation of the card interface 17 and display/keypad 18, and is also connected to an hhu port 20 for connection to the hhu 5 as previously described. The CDT 3 is generally located remotely from the meter 2 at a more convenient access point in the consumer's premises. Again, the CDT 3 is powered by battery (not shown) such as a single lithium battery.

In operation of the metering apparatus 1, the CDT controller 19 monitors consumption of gas against available credit and the state of the valve 13 is controlled accordingly. The CDT controller 19 maintains a record of the input credit and periodically polls the meter controller 14 by transmitting a request signal over the communications link 4. The meter controller 14 responds to this request by transmitting the current meter reading (and status data indicating any fault or alarm conditions due to tampering). From the current meter reading, the CDT controller 19 determines the amount of consumption since the last poll, and updates the available credit accordingly. The CDT controller 19 then calculates the volume of gas consumption allowed to the consumer based on the available credit and the applicable tariff which is stored in an internal memory of the controller 19. The CDT controller 19 then calculates the meter reading at which the allowed consumption will be reached, and transmits this limit reading to the meter controller 14. The meter controller 14 will then close the valve 13 when the limit reading is reached unless a new, higher limit reading is subsequently transmitted by the CDT controller 19. The valve 13 will remain closed until the CDT controller 19 transmits a new limit reading after further credit has been input by the consumer.

When the customer card 7 is inserted in the CDT 3, the purchased credit is loaded to the CDT controller as previously described, but the CDT controller 19 also writes various data to the card 7. This data will be read by the POS 8, and hence communicated to the central controller 10, the next time the card is presented to the POS to purchase new credit. The data written to the card 7 may include, for example, current meter reading and status data. In this embodiment, however, the CDT controller 19 also writes battery usage data to the card 7 as described in more derail below.

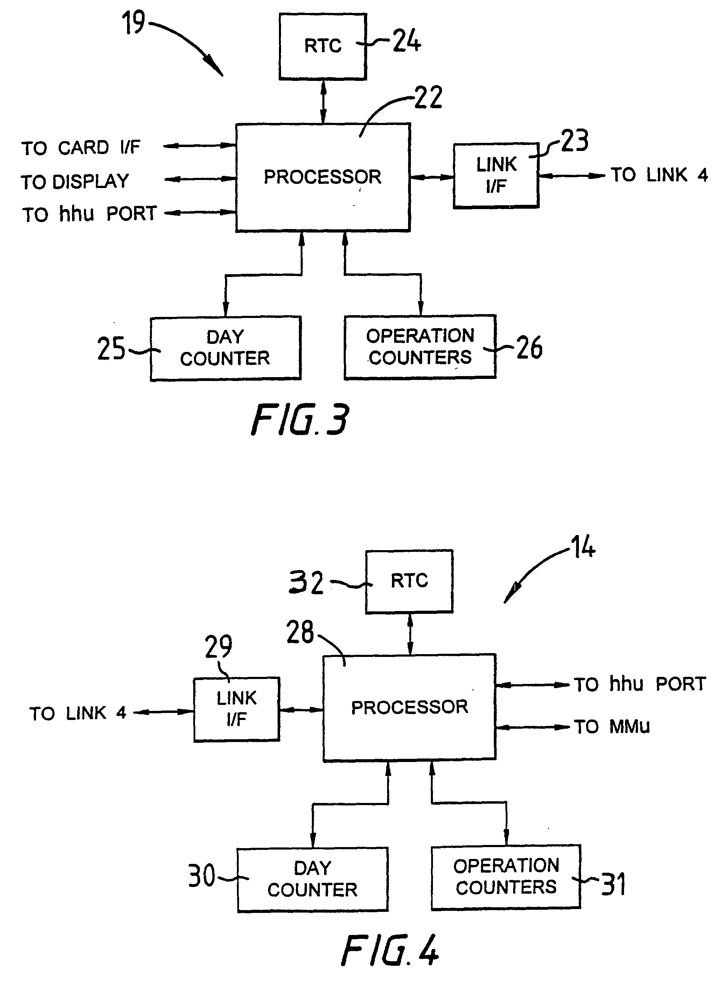

As part of the maintenance of the apparatus 1 it is necessary to determine when the batteries in the meter 2 and CDT 3 are running low so that these can be replaced by a service engineer. For this purpose, the CDT controller 19 and meter controller 14 each record battery usage data relating to their respective batteries. In this embodiment, each controller 14, 19 maintains a count of the number of days that have passed since the battery was inserted, and also a count of the number of times each of various types of operation are performed. Figure 3 shows the main elements of the CDT controller 19 in more detail. As illustrated, the controller 19 comprises a control processor 22 which is connected to the elements 17, 18 and 20 of Figure 2, and also to a link interface 23 which transmits data over the link 4 to the meter 2 and receives data therefrom. The processor 22 is also connected to a real time clock (RTC) 24 to enable the passage of time to be monitored. In accordance with the RTC 24, the processor 22 increments a day counter 25 to maintain a count of the number of days that have passed since the CDT battery was inserted by the service engineer. The day counter 25 is reset by the processor 22 when a new battery is inserted in response to a control input supplied either from the hhu 5 or entered via the keypad 18. The processor 22 also maintains various operation counters indicated schematically at 26. These counters indicate the number of times each of various specified operations are performed by the CDT controller. In this embodiment, four operation counters 26 are maintained by the processor 22 for the following operations:

- communications between the CDT and meter
- customer card insertions
- display activations
- accounting calculations

Thus, each time one of the above operations is performed, the CDT controller 19 increments the appropriate operation counter 26. Again, the operation counters 26 are reset by the service engineer when the CDT battery is replaced.

Figure 4 shows the similar structure of the meter controller 14 in this embodiment. The controller 14 comprises a control processor 28 which is connected to the hhu port 15 and MMU 12 and to a link interface 29 for transmission of data to and from the link 4. The processor 28 is also provided with an RTC 32 and maintains a day counter 30 and various operation counters indicated schematically at 31. The day counter 30 indicates the number of days since the meter battery was inserted in the same way the CDT day counter 25. In this embodiment, there are three operation counters 31 for the following operations:

- gas pulse detection and meter reading update
- opening/closing the gas valve 13
- communications between the meter controller and CDT

Thus, each time one of the above operations is performed by the meter controller 14, the processor 29 increments the appropriate operation counter. The counters 30, 31 are reset by the service engineer when the meter battery is replaced by means of a control input entered via the hhu 5.

The various counters 25, 26, 30 and 31 are preferably maintained in non-volatile memory associated with the processors 22 and 28. The operation counters can be updated each time the various operations are performed. However, to reduce the number of writes to the non-volatile memories, the processors 22, 28 may maintain temporary daily records in internal RAMs and update the main counters in non-volatile memory when updating the day counters 25, 30.

For overall management of battery replacements, each time the customer card 7 is inserted in the CDT 3 the current battery usage data is written to the card 7 by the CDT controller 19. In more detail, the CDT processor 22 accesses the counters 25, 26 and (after adding any daily operation counts stored in RAM to the operation count values) writes these values to the card 7 as CDT battery usage data. The CDT processor 22 also polls the meter controller 14 for the current meter battery usage data, and the meter processor 28 similarly retrieves the various count values and transmits these to the CDT processor 22. The CDT processor 22 then writes these values to the card 7 as meter battery usage data. The next time the card 7 is presented to the POS 8, the POS will read the battery usage data and transmit this to the central controller 10.

All the processing required to determine the remaining battery capacity for the metering and CDT batteries, and hence whether these batteries should be replaced. is performed by the central controller 12. This processing can be far more sophisticated than could be performed practically in the metering apparatus itself, and can be performed with reference not only to manufacturer's data, but also by reference to statistical data derived from empirical measurements of various aspects of the operation of CDTs 3 and meters 2. Statistics based on empirical measurements on the batteries used in the system may also be employed.

In this example, the central controller 10 is programmed with the energy consumption values for each of the operations counted by the operation counters 26, 31 and uses these together with the battery data and day count values to estimate the remaining battery capacity. In particular, in this example, the controller 10 is preprogrammed with the following data (where the figures are given by way of illustration only):

- nominal battery capacity when new        18000mA hours
- battery self-discharge current        3% of nominal per year

- CDT standby current        0.1mA
- meter standby current        0.1mA

together with the following data indicating energy consumption of the various operations:

| CDT OPERATION | CURRENT | DURATION |
|---|---|---|
| Card insertion | 30mA | 5 seconds |
| CDT/meter communications | 30mA | 1 second |
| Activating electronic display | 5mA | 1 minute |
| Accounting calculation | 10mA | 1 second |

| METER OPERATION | CURRENT | DURATION |
|---|---|---|
| Pulse detection and meter reading update | 5mA | 1 second |

(continued)

| METER OPERATION | CURRENT | DURATION |
|---|---|---|
| Opening/closing gas valve | 10mA | 1 second |
| Meter/CDT communications | 30mA | 1 second |

To illustrate the calculation performed by the controller 10 for the CDT battery, assume the day counter indicates 625 days, and the operation counters indicate 80 card insertions, 6000 CDT/meter communications, 1800 display activations, and 800 accounting calculations. The battery capacity used can then be calculated as follows:

| | |
|---|---|
| Standby current consumption = 625 x 24 x 0.1 | = 1500mA hours |
| Self-discharge = 3% x $\frac{625}{365}$ x 18000 | = 924.7mA hours |
| Card insertions = 80 x 30 x $^5/_{3600}$ | = 3.3mA hours |
| Communications = 6000 x 30 x $^1/_{3600}$ | = 50mA hours |
| Display activations = 1800 x 5 x $^1/_{60}$ | = 150mA hours |
| Accounting calculations = 800 x 10 x $^1/_{3600}$ | = 2.2mA hours |
| **TOTAL** | **= 2630.2** |

Thus, the remaining battery capacity = 18000 - 2630.2 = 15369.8mA hours.

The central controller 10 compares this value to a threshold value which is set based on the battery's load curve and other empirical data (such as the expected daily energy consumption for a typical metering apparatus) to determine if the CDT battery should be replaced. The threshold should allow sufficient time to arrange a visit from a service engineer with a suitable margin of safety to allow for the possibility of errors. When the remaining battery capacity is below the threshold, the central controller 10 generates an indication to an operator that the battery requires replacement. This could be done by automatic generation of the service engineers' work schedules, in which case a suitable entry for replacement of the CDT battery at the particular consumer's premises will be made.

It will be appreciated that the meter battery capacity can be calculated in a similar way to the above based on the data stored in the central controller 10. The above example also illustrates the fact that the main drain on the battery is due to the standby current, since for much of the time the CDT 3, and similarly the meter 2, will be in the standby mode. Thus, in some embodiments, the CDT 3 and meter 2 may simply maintain day counters 25, 30, and this will enable the central controller 10 to derive a reasonable estimate of the remaining battery capacity based on the known standby currents and battery characteristics. In such embodiments, however, the central controller could be preprogrammed with the expected energy consumption rate due to various other operations. This can be derived from statistical analysis of measurements of operating patterns of metering apparatus in the system to determine a typical usage pattern. This expected consumption can then be taken into account in the processing operation even where the metering apparatus itself only records day counts.

As will be apparent to those skilled in the art, various different algorithms may be used for calculation of remaining battery capacity and setting of the threshold value, in dependence on the particular characteristics of the battery in question and the data provided by the manufacturer and/or derived from empirical measurements It will also be appreciated that empirical data other than that specifically mentioned above may be employed if desired. For example, the statistical data stored in the central controller 10 may be further improved by taking regular samples of batteries from metering apparatus in use and accurately measuring the remaining capacity. By correlating the results with the number of operations recorded by the operation counters in the apparatus, it will be possible to fine tune the values used in the processing algorithms for different types of operation.

In the embodiments described above, when the service engineer visits the consumer's premises the hhu 5 may be used to retrieve the current count values from the meter and CDT for relay to the central controller 10. Alternatively, the hhu 5 may be programmed with the same data and processing algorithms as the central controller 10 to enable the engineer to determine on-site if either battery requires replacement.

It will be appreciated that the above provides an efficient system for monitoring of battery capacity and management of battery replacement in the metering system. The metering apparatus itself need only maintain simple counters as described above, and the analysis and processing of the data is performed externally allowing more sophisticated processing operations to be performed where desired to increase useful battery life. Further, overall management of battery replacements can be performed without reliance on the consumer.

It will of course be appreciated that, while preferred embodiments of the invention have been described above, various changes and modifications may be made without departing from the scope of the invention.

**EP 0 981 758 B1**

**Claims**

1.  A metering system (1, 2, 3, 5, 7, 8, 10, 12, 13, 14, 15, 17, 18, 19, 20) for metering the supply of a service (G) to a consumer, the system comprising:-

    a metering apparatus (1, 2, 12, 13) for metering the service (G);
    at least one battery for powering the metering apparatus (1, 2, 12, 13);
    control means (14, 19) for controlling the metering apparatus (1, 2, 12, 13) and for recording battery usage data, the battery usage data comprising data indicating the operating time of the metering apparatus (1, 2, 12, 13) since insertion of the battery therein;
    data output means (15, 17, 20) for outputting the battery usage data from the control means (14, 19); and
    external data processing means (5, 8, 10) for processing the battery usage data received from the data output means (15, 17, 20);

    **characterised in that** the external data processing means (5, 8, 10) estimates the used capacity of the battery in accordance with the operating time and pre-stored data indicative of the energy consumption of the metering apparatus (1, 2, 12, 13) in standby mode of operation.

2.  A system according to claim 1, wherein the battery usage data comprises data indicating the number of times an operation has been performed by the system in use.

3.  A system according to claim 1 or 2, wherein the pre-stored data comprises expected energy consumption rates relating to a plurality of operation types performed by the system in use.

4.  A system according to any one of the preceding claims, wherein the external data processing means (5, 8, 10) estimates the used capacity of the battery in accordance with the battery usage data and the pre-stored data.

5.  A system according to any one of the preceding claims, wherein the metering apparatus (1, 2, 12, 13) comprises a meter (2, 12, 13) powered by a first battery and a control unit (3) powered by a second battery, the control means (14, 19) being arranged to record battery usage data for each of the first and second batteries.

6.  A system according to claim 5, wherein the external data processing means (5, 8, 10) processes the battery usage data for each of the first and second batteries to determine if the battery should be replaced.

7.  A system according to any one of the preceding claims, wherein the external data processing means (5, 8, 10) comprises a central controller (10) of the system.

8.  A system according to claim 7, wherein the data output means (15, 17, 20) comprises a card interface (17) arranged to write the battery usage data to a memory card (7) for communication with the central controller (10) during a credit purchase operation in which the card (7) is read by a card reader (8).

9.  A system according to claim 7 or 8, wherein the data output means (15, 17, 20) comprises at least one communications port (15, 20) for communicating the battery usage data to a hand-held unit (5) which is operable to communicate said data to the external data processing means.

10. A system according to any one of claims 1 to 6, wherein the external data processing means (5, 8, 10) comprises a hand-held unit (5), the data output means (15, 17, 20) comprising at least one communications port (15, 20) for communicating battery usage data to the hand-held unit (5).

11. Use of a metering system according to any one of the preceding claims, comprising the following steps:

    recording the battery usage data;
    communicating the battery usage data to the external data processing means (5, 8, 10); and
    processing the battery usage data in the external data processing means to determine if the battery should be replaced.

7

**EP 0 981 758 B1**

**Patentansprüche**

1. Meßsystem (1, 2, 3, 5, 7, 8, 10, 12, 13, 14, 15, 17, 18, 19, 20) zum Messen der Lieferung eines Dienstes (G) an einen Verbraucher, das umfaßt:

   eine Meßvorrichtung (1, 2, 12, 13) zum Messen des Dienstes (G);

   wenigstens eine Batterie zum Versorgen der Meßvorrichtung (1, 2, 12, 13);

   ein Steuermittel (14, 19) zum Steuern der Meßvorrichtung (1, 2, 12, 13) und zum Aufzeichnen von Batterienutzungsdaten, wobei die Batterienutzungsdaten Daten umfassen, die die Betriebszeit der Meßvorrichtung (1, 2, 12, 13) seit dem Einsetzen der Batterie angeben;

   ein Datenausgabemittel (15, 17, 20) zum Ausgeben der Batterienutzungsdaten vom Steuermittel (14, 19); und

   ein externes Datenverarbeitungsmittel (5, 8, 10) zum Verarbeiten der Batterienutzungsdaten, die von dem Datenausgabemittel (15, 17, 20) empfangen worden sind;

   **dadurch gekennzeichnet, daß**
   das externe Datenverarbeitungsmittel (5, 8, 10) die verbrauchte Batteriekapazität entsprechend der Betriebszeit und den im voraus gespeicherten und den Energieverbrauch der Meßvorrichtung (1, 2, 12, 13) im Bereitschaftsbetriebsmodus angebenden Daten schätzt.

2. System nach Anspruch 1, bei dem die Batterienutzungsdaten Daten umfassen, die die Anzahl der Ausführungen einer Operation des Systems im Gebrauch anzeigen.

3. System nach Anspruch 1 oder 2, bei dem die im voraus gespeicherten Daten erwartete Energieverbrauchsraten bezüglich mehrerer vom System im Gebrauch durchgeführter Operationstypen umfassen.

4. System nach einem der vorangehenden Ansprüche, bei dem das externe Datenverarbeitungsmittel (5, 8, 10) die verbrauchte Batteriekapazität entsprechend den Batterienutzungsdaten und den im voraus gespeicherten Daten schätzt.

5. System nach einem der vorangehenden Ansprüche, bei dem die Meßvorrichtung (1, 2, 12, 13) ein Meßgerät (2, 12, 13), das von einer ersten Batterie versorgt wird, und eine Steuereinheit (3), die von einer zweiten Batterie versorgt wird, umfaßt, wobei das Steuermittel (14, 19) so konfiguriert ist, daß es Batterienutzungsdaten jeweils für die erste und die zweite Batterie aufzeichnet.

6. System nach Anspruch 5, bei dem das externe Datenverarbeitungsmittel (5, 8, 10) die Batterienutzungsdaten für jeweils die erste und die zweite Batterie verarbeitet, um zu ermitteln, ob die Batterie ausgetauscht werden soll.

7. System nach einem der vorangehenden Ansprüche, bei dem das externe Datenverarbeitungsmittel (5, 8, 10) eine zentrale Steuervorrichtung (10) des Systems umfaßt.

8. System nach Anspruch 7, bei dem das Datenausgabemittel (15, 17, 20) eine Kartenschnittstelle (17) umfaßt, die so beschaffen ist, daß sie die Batterienutzungsdaten in eine Speicherkarte (7) schreibt, um sie während einer Krediterwerbungsoperation, bei der die Karte (7) von einem Kartenleser (8) gelesen wird, an die zentrale Steuervorrichtung (10) zu übermitteln.

9. System nach Anspruch 7 oder 8, bei dem das Datenausgabemittel (15, 17, 20) wenigstens einen Kommunikationsanschluß (15, 20) für die Übermittlung der Batterienutzungsdaten an eine tragbare Einheit (5), die so betrieben werden kann, daß sie die Daten an das externe Datenverarbeitungsmittel übermittelt, umfaßt.

10. System nach einem der Ansprüche 1 bis 6, bei dem das externe Datenverarbeitungsmittel (5, 8, 10) eine tragbare Einheit (5) umfaßt, wobei das Datenausgabemittel (15, 17, 20) wenigstens einen Kommunikationsanschluß (15, 20) für die Übermittlung der Batterienutzungsdaten zur tragbaren Einheit (5) umfaßt.

11. Verwendung eines Meßsystems nach einem der vorangehenden Ansprüche, bei der

die Batterienutzungsdaten aufgezeichnet werden;

die Batterienutzungsdaten an das externe Datenverarbeitungsmittel (5, 8, 10); übermittelt werden; und

die Batterienutzungsdaten im externen Datenverarbeitungsmittel verarbeitet werden, um zu ermitteln, ob die Batterie ausgetauscht werden muß.

**Revendications**

1. Système de mesure (1, 2, 3, 5, 7, 8, 10, 12, 13, 14, 15, 17, 18, 19, 20) destiné à mesurer la fourniture d'un service (G) à un consommateur, le système comprenant :

   un appareil de mesure (1, 2, 12, 13) destiné à mesurer le service (G) ;
   au moins, une batterie destinée à alimenter l'appareil de mesure (1, 2, 12, 13) ;
   des moyens de contrôle (14, 19) destinés à contrôler l'appareil de mesure (1, 2, 12, 13) et à enregistrer des données d'usage de la batterie, les données d'usage de la batterie comprenant des données indiquant le temps de fonctionnement de l'appareil de mesure (1, 2, 12, 13) depuis l'insertion de la batterie à l'intérieur de celui-ci ;
   des moyens de sortie de données (15, 17; 20) destinés à sortir les données d'usage de la batterie à partir des moyens de contrôle (14, 19) ; et
   des moyens de traitement de données externes (5, 8, 10) destinés à traiter les données d'usage de la batterie reçues à partir des moyens de sortie de données (15, 17, 20) ;

   **caractérisé en ce que** les moyens de traitement de données externes (5, 8, 10) estiment la capacité utilisée de la batterie en fonction du temps de fonctionnement et de données pré-enregistrées qui indiquent la consommation d'énergie de l'appareil de mesure (1, 2, 12, 13) dans un mode de fonctionnement de secours.

2. Système selon la revendication 1, dans lequel les données d'usage de la batterie comprennent des données qui indiquent le nombre de fois qu'une opération a été réalisée par le système en fonctionnement.

3. Système selon la revendication 1 ou 2, dans lequel les données pré-enregistrées comprennent des taux de consommation d'énergie attendus par rapport à une pluralité de types d'opération réalisés par le système en fonctionnement.

4. Système selon l'une quelconque des revendications précédentes, dans lequel les moyens de traitement de données externes (5, 8, 10) estiment la capacité utilisée de la batterie en fonction des données d'usage de la batterie et des données pré-enregistrées.

5. Système selon l'une quelconque des revendications précédentes, dans lequel l'appareil de mesure (1, 2, 12, 13) comprend un compteur (2, 12, 13) alimenté par une première batterie et une unité de contrôle (3) alimentée par une seconde batterie, les moyens de contrôle (14, 19) étant agencés de manière à enregistrer les données d'usage de la batterie pour chacune des première et seconde batteries.

6. Système selon la revendication 5, dans lequel les moyens de traitement de données externes (5, 8, 10) traitent les données d'usage de la batterie pour chacune des première et seconde batteries afin de déterminer si la batterie doit être remplacée.

7. Système selon l'une quelconque des revendications précédentes, dans lequel les moyens de traitement de données externes (5, 8, 10) comprennent un dispositif de contrôle central (10) du système.

8. Système selon la revendication 7, dans lequel les moyens de sortie de données (15, 17, 20) comprennent une interface de carte (17) agencée de manière à écrire les données d'usage de la batterie sur une carte de mémoire (7) pour effectuer une communication avec le dispositif de contrôle central (10) pendant une opération d'achat de crédit dans laquelle la carte (7) est lue par un lecteur de carte (8).

9. Système selon la revendication 7 ou 8, dans lequel les moyens de sortie de données (15, 17, 20) comprennent au moins un accès de télécommunications (15, 20) pour communiquer les données d'usage de la batterie à une unité portative (5) qui est fonctionnelle pour communiquer lesdites données aux moyens de traitement de données externes.

10. Système selon l'une quelconque des revendications 1 à 6, dans lequel les moyens de traitement de données externes (5, 8, 10) comprennent une unité portative (5), les moyens de sortie de données (15, 17, 20) comprenant au moins un accès de télécommunications (15, 20) destiné à communiquer les données d'usage de la batterie à l'unité portative (5).

11. Utilisation d'un système de mesure selon l'une quelconque des revendications précédentes, comprenant les étapes suivantes :

l'enregistrement des données d'usage de la batterie ;
la communication des données d'usage de la batterie aux moyens de traitement des données externes (5, 8, 10) ; et
le traitement des données d'usage de la batterie dans les moyens de traitement de données externes afin de déterminer si la batterie doit être remplacée.

FIG.1

FIG.2

EP 0 981 758 B1

FIG.3

FIG.4